# EUROPEAN PATENT SPECIFICATION

(11) **EP 3 186 189 B1**
(45) Date of publication and mention of the grant of the patent: **22.07.2026**
(21) Application number: 14899403.1
(22) Date of filing: 04.08.2014
(51) Int. Cl.: B81B 3/00, H02N 1/00, G02B 26/08, B25J 7/00

(54) **PISTON-TUBE ELECTROSTATIC MICROACTUATOR**
ELEKTROSTATISCHER MIKROAKTUATOR MIT KOLBEN-ROHR
MICRO-ACTIONNEUR ÉLECTROSTATIQUE À TUBES ET PISTONS

(43) Date of publication of application: 05.07.2017
(73) Proprietor: Sheba Microsystems Inc., Toronto, ON M5G 1L7 (CA)
(72) Inventor: Ba-Tis, Faez, East York, ON M4H 1L7 (CA); Ben-Mrad, Ridha, Toronto, ON M4R 1B5 (CA)
(74) Representative: Hocking, Adrian Niall
(86) International application number: PCT/IB2014/001498
(87) International publication number: WO 2016/020716

(56) References cited:
- WO-A2-2010/038229
- WO-A2-2013/083534
- CN-U- 203 643 683
- CN-U- 203 705 471
- US-A1- 2013 139 592
- US-A1- 2014 028 897

## Description

### FIELD OF THE INVENTION

The invention relates to the field of microactuators that provide high force, large out-of-plane translation stroke and/or bi-axial rotation.

### BACKGROUND OF THE INVENTION

Large out-of-plane translation and high output force microactuators have a wide range of applications in adaptive optics and in micro robotics. In adaptive optics, they are used for auto-focus [1] and Optical Image Stabilization (OIS) in miniature cameras [2] and deformable micromirrors [3]. For the auto-focus in phone cameras application, the actuator is required to translate a lens of 3 mg in mass along the optical axis for 80 µm [4]. The OIS in phone cameras requires a rotation of a lens barrel of 45 mg mass [2] for 1° about two axes in order to cancel any effects hand-shaking has on the images and recorded video. In micro robotics, large stroke and high output force actuators are used in micro assembly systems and microgrippers [5][6].

Different micro actuation methods are in use. These include electromagnetic, piezoelectric, and electrostatic microactuators. The electromagnetic actuators provide large stroke and high output force; nevertheless, they are known to have a number of disadvantages such as high power consumption and large size [7][4]. Although piezoelectric actuators provide high output force, they are sensitive to temperature and are difficult to fabricate [1][8]. Electrostatic actuators offer high speed response, low power consumption, and small size [9][7][4]. However, it is challenging to design electrostatic actuators that can simultaneously provide high output force, large out-of-plane stroke and while maintaining a low voltage [10].

The electrostatic actuators that provide an out-of-plane stroke include parallel plate and Vertical Comb-Drive (VCD) actuators. The former suffers from the pull-in effect which limits the vertical stroke of the actuator to one third of the initial gap between the plates [9]. The latter could be divided into two types: rotational and translational (piston-style) VCD actuators.

In rotational comb-drive actuators (including staggered and angular VCD actuators), the original motion of the rotor is a rotation, thus providing a rotational out-of-plane stroke; however, these actuators often utilize mechanical amplification mechanisms, such as levers, to enlarge the stroke as well as to transform the original rotary motion of the rotor into a translation of the load. Due to the motion amplification and transformation, the output torque of the actuator acting on the load is generally lower than the one generated. Different designs of rotational VCD actuators have been developed. For example, a rotational VCD actuator developed by V. Milanovic et al. [11] achieved a vertical deflection of 60 µm (corresponding to an angle of rotation of 20°) at 150 V. It utilizes a cantilever for mechanical amplification. Li et al. [12] developed a rotational (staggered) VCD actuator that achieved a vertical deflection of 180 µm at 35 V. A plate was attached to the free comb of the actuator to achieve the large rotational stroke while reducing the output torque.

US Patent 8,358,925 B2 [13] discloses an invention of a rotational comb-drive actuator that is used to translate a lens along the optical axis (z). The original motion of the rotor is an out-of-plane rotation which is transformed (with the assistance of similar actuators surrounding the lens) into a vertical deflection of the lens using a complex transformation mechanism. A significant amount of the rotor torque is dissipated during the transformation of the motion. Due to the complexity of the structure of the rotor of this actuator, an undesirable tilt occurs during the translation of the lens when it is actuated by a number of similar actuators. This tilt needs a motion controller to be eliminated.

U.S. Patent No. 8,269,395 B2 [14] discloses a large stroke rotational comb-drive actuator. It works on the repulsive force principle, and the rotor of the actuator achieves an 86 µm vertical deflection at 200 V based on a rotational stroke at each of the four edges of the actuator which is then amplified using a cantilever beam; however, it provides a low output torque due to use of an amplification mechanism and to the small area of the fingers used to generate the force.

In translational VCDs, the original motion of the rotor is a translation, and the total electrostatic force that is developed between the electrodes is directly applied to the load attached to the rotor without the use of any stroke amplification or transformation mechanism. A number of translational VCD actuators were developed. A translational VCD actuator, developed by V. Milanovic et al., achieved a translation stroke of 15 µm at 140 V. The actuator is fabricated using a Direct Reactive Ion Etching (DRIE) of an SOI wafer which enables the fabrication of large height electrodes; however, it provides a low output force as the comb electrode configuration is not area-efficient in terms of overall electrode capacitance. That is because the rotor of the actuator consists of two arrays of fingers (each array is formed along one side of the rotor). The number of fingers in these two arrays can be increased only along one direction, i.e. the lateral direction of comb fingers [11]. A self-aligned translational VCD actuator [15], developed by E. Carr et al., was able to achieve a stroke of only 1.4 µm due to the high stiffness of the supporting beams along the z-axis (out-of plane axis) and due to the low output force that can be generated by the actuator which is attributed to the area-inefficient configuration as is the case in the previous translational VCD actuators [11].

U.S. Patent No. 6,384,952 B1[16] discloses a translational vertical comb-drive actuator used to actuate a deformable mirror. The actuator has a cavity-tooth configuration which enables achieving a wide area for the electrodes, and it provides an out-of-plane translation of 20 µm at 100 V; however, the actuator provides only 1-DOF motion, i.e. vertical translation. The differences in the translations of the VCD actuators beneath the mirror surface result in a bi-axial rotation of the mirror surface. In other words, the comb-drive actuators have only 1-DOF motion which is a translation along the z-axis, whereas the mirror surface itself has a 3-DOF motion, i.e. translation along the z-axis, and bi-axial rotation about the in-plane axes (x and y). A limitation of this actuator is that the tooth-cavity configuration requires the rotor and the stator of the actuator to be fabricated separately. The fabricated rotor and stator wafers are then bonded together which may lead to a misalignment of sub-microns size between the upper and lower electrodes. This misalignment limits the stroke of the actuator. The cavity-tooth configuration also leads to gas damping effect between the comb electrodes as gas is trapped between the tooth and the corresponding cavity during motion of the actuators. This trapped gas has only one outlet (exit) during the actuation, which is the gap between the moving and fixed fingers. This gap is usually very small in size as compared to the finger width.

US Patent No. 7,538,471 B2 [17] discloses a vertical comb-drive actuator configuration that provides an increased rigidity to the optical surface. The goal of the invention is to overcome the problem of optical surface deformation that ensues from the deposition of a reflective metal such as gold or aluminum on the optical surface to enhance its reflectivity. The invention eliminates this problem by reinforcing the comb electrodes beneath the reflected surface in more than one direction. The actuator provides 3-DOF motion, i.e. translation along the z-axis and bi-axial rotation about the in-plane axes (*x* and *y*), without the use of any stroke amplification mechanism. It also provides a considerable large output force due to the ability of the electrode configuration to be expanded in more than one dimension. The actuator is fabricated using a surface micromachining process in which the height of the comb electrodes is limited due to the nature of the layer deposition process. These layers cannot be of a large height (thickness), which leads to a limitation on the out-of-plane translation of the actuator. In addition, the comb electrodes have a tooth-cavity configuration that contributes to appreciable damping effects, similar to the issue listed in conjunction with U.S. Patent No. 6,384,952 B1.

A recent US Patent No. 8,711,495 discloses a MEMS autofocus mechanism that utilizes three or more translation vertical comb-drive actuators to achieve autofocus in phone cameras. The goal of this invention is to increase the resistance of MEMS Autofocus structure to shocks that occur during the drop test of the mobile phone. The drawbacks of this actuation mechanism include inefficient area-electrode layout, as it utilizes single array comb-drive actuators distributed around the lens, meaning a higher driving voltage is required; limited out-of-plane translational stroke, as the maximum height (thickness) of the electrodes is 20 microns; and low resonant frequency, as the supporting beams have to buckle during the loading of the lens to the central ring to provide an offset between the comb fingers.

One example of a MEMS electrostatic micro actuator is disclosed in WO2010/038229A2.

In summary, the prior art translational (piston-style motion) VCD actuators have limited performance as they are unable to achieve simultaneously a large output force and a large stroke due to one or more of the following reasons:
(1) Inefficient electrode configurations of the conventional VCD actuators in which the comb fingers have an array-style structure. This structure allows multiplying the number of the fingers only in one dimension along the lateral axis of the fingers; therefore, it leads to generating a low output force. In other words, the comb fingers are essentially free-end cantilevers; hence they cannot be largely elongated along the longitudinal axis to increase the output force. Therefore, the output force can be increased by multiplying the comb fingers only along the lateral axis of the comb fingers.
(2) Bonding misalignments between the rotor and stator electrodes might arise if a translational VCD actuator with a cavity-tooth configuration is fabricated using a bulk micromachining fabrication process.
(3) Significant damping effects in the cavity-tooth configuration of the comb electrodes used in a number of designs that limit the bandwidth of the actuator.
(4) Surface micromachined VCD actuators are limited in terms of being able to provide a large translational (piston-style) stroke. This limitation is due to the inability of surface micromachining processes for depositing large height (thickness) layers.

### SUMMARY OF THE INVENTION

In order to overcome the previously listed problems associated with VCD actuators, a novel electrostatic actuator that utilizes a piston-tube type configuration is developed, and as is defined in the appended claims. The actuator consists of two structures: a fixed one and a moving one . The fixed structure contains a plurality of electrodes which act as pistons in a piston-tube type system. The pistons or teeth may be arranged in square, circular, or any other configuration. These pistons are attached to a base (i.e. the base surfaces on which the piston are positioned define the xy plane) and protrude in a perpendicular direction to it (i.e. along the z-axis), and they form the stator of the actuator. The moving structure contains a plurality of tubes (through holes) that have cross-sections similar to the cross-sections of the pistons. The moving tubes surround an actuator plate, and they are suspended by three or more supporting springs used to return the actuator plate to its initial position in the absence of an applied voltage. The pistons can be divided into three or more groups that are electrically separated from each other to provide bi-axial rotation about the in-plane axes (x and y).

When a voltage is applied across the rotor and all of the stators, an electrostatic force develops between the adjacent pistons and tubes in the vertical direction. This electrostatic force moves the rotor (the free moving structure) from its static position towards the stators (the fixed structure) in a pure translation (piston-style) motion along the z-axis. When the voltage drops, the rotor moves back to its equilibrium position due to the restoring force in the supporting springs. To rotate the rotor of the actuator about the x and/or y axes, a voltage is applied across the rotor and only one or more stators.

The advantages of the present invention compared to the prior art are as follows:
(1) The piston-tube configuration enables the use of a wide area for the electrodes. Therefore, a high output force in the translation mode (or a high torque in rotation mode) can be generated.
(2) The piston-tube configuration significantly reduces the gas damping effects between the actuator electrodes, which is an inherent issue of the cavity-tooth configuration actuators listed previously. That is because no gas is trapped between the pistons and the tubes when they engage during the motion as the tubes are through holes. Squeeze thin-film damping is still present in one embodiment of this actuator, but it can be eliminated by back etching of the fixed structure (the base) to create a central through hole beneath the actuator plate.
(3) The design enables the fabrication of actuator electrodes with an accurate alignment. That is due to the fact that the rotor tubes are patterned and etched after the bonding of the rotor layer (moving structure) to the etched stator layer (fixed structure) using double sided alignment. This technique leads to an accurate alignment between the adjacent pistons and tubes.
(4) The piston-tube configuration with double stator embodiment (two stators bound to the rotor from its two sides that are parallel to the base) enables bi-directional translation of the rotor along the z-axis so that the stroke of the actuator is doubled.
(5) The piston-tube actuator provides 3-DOF motion, i.e. translation along the z-axis, and bi-axial rotation about the x and y axes.

These advantages can be further described through information presented in the following sections.

### BRIEF DESCRIPTION OF DRAWINGS

Embodiments herein will hereinafter be described in conjunction with the appended drawings provided to illustrate and not to limit the scope of the claims, wherein like designations denote like elements, and in which:
**FIG. 1A** illustrates the fixed structure (pistons) of Embodiment 1 of the 3-DOF piston-tube electrostatic actuator.
**FIG. 1B** illustrates the moving structure (tubes) of Embodiment 1 of the 3-DOF piston-tube electrostatic actuator.
**FIG. 1C** is a perspective view illustrating the final structure of Embodiment 1 of the 3-DOF piston-tube electrostatic actuator.
**FIG. 1D** illustrates a top, detailed view, and a cross-section view of the final structure of Embodiment 1 of the 3-DOF piston-tube electrostatic actuator.
**FIG. 2A** is a perspective view illustrating the fixed structure (pistons) of Embodiment 2 of the 3-DOF piston-tube electrostatic actuator.
**FIG. 2B** is a perspective view illustrating the moving structure (tubes) of Embodiment 2 of the 3-DOF piston-tube electrostatic actuator.
**FIG. 2C** is a perspective view illustrating the final structure of Embodiment 2 of the 3-DOF piston-tube electrostatic actuator.
**FIG. 2D** illustrates a top, detailed view of the final structure of Embodiment 2 of the 3-DOF piston-tube electrostatic actuator (i.e. black structure within the tubes represent the pistons).
**FIG. 3A** is a perspective view illustrating the fixed structure (pistons) of Embodiment 3 of the 3-DOF piston-tube electrostatic actuator.
**FIG. 3B** is a perspective view illustrating the moving structure (tubes) of Embodiment 3 of the 3-DOF piston-tube electrostatic actuator.
**FIG. 3C** is a perspective view illustrating the final structure of Embodiment 3 of the 3-DOF piston-tube electrostatic actuator.
**FIG. 4A** is an exploded view of Embodiment 4 (double stators version) of the 3-DOF piston-tube electrostatic actuator illustrating the lower fixed base containing pistons, the rotor containing the tubes, and the upper fixed base containing pistons.
**FIG. 4B** is a perspective view of Embodiment 4 (double stators version) of the 3-DOF piston-tube electrostatic actuator illustrating the final form of the actuator after the bonding of the three structures.
**FIG. 4C** is a top view illustrating the final structure of Embodiment 4 of the 3-DOF piston-tube electrostatic actuator.
**FIG. 4D** is a cross-sectional view illustrating the final structure of Embodiment 4 of the 3-DOF piston-tube electrostatic actuator.
**FIG. 5A** is an SEM micrograph illustrating the top view of the fabricated prototype of Embodiment 1 of the 3-DOF piston-tube electrostatic actuator.
**FIG. 5B** is an SEM micrograph illustrating the top view of the rotor and the stator of the fabricated prototype of Embodiment 1 of the 3-DOF piston-tube electrostatic actuator.
**FIG. 5C** is an SEM micrograph illustrating a magnified top view of part of the rotor and the stator and a spring of the fabricated prototype of Embodiment 1 of the 3-DOF piston-tube electrostatic actuator.
**FIG. 5D** is an SEM micrograph illustrating the alignment accuracy of the fabricated prototype of Embodiment 1 of the 3-DOF piston-tube electrostatic actuator.
**FIG. 6** shows a snapshot of the prototype actuator of Embodiment 1 of the 3-DOF piston-tube electrostatic actuator loaded with a mass of 1 mg during output force testing.
**FIG. 7** shows the translational stroke of the fabricated prototype actuator versus applied voltage.

### DETAILED DESCRIPTION OF THE INVENTION

The invention relates to a MEMS electrostatic microactuator as defined in claim 1.

### Embodiment 1

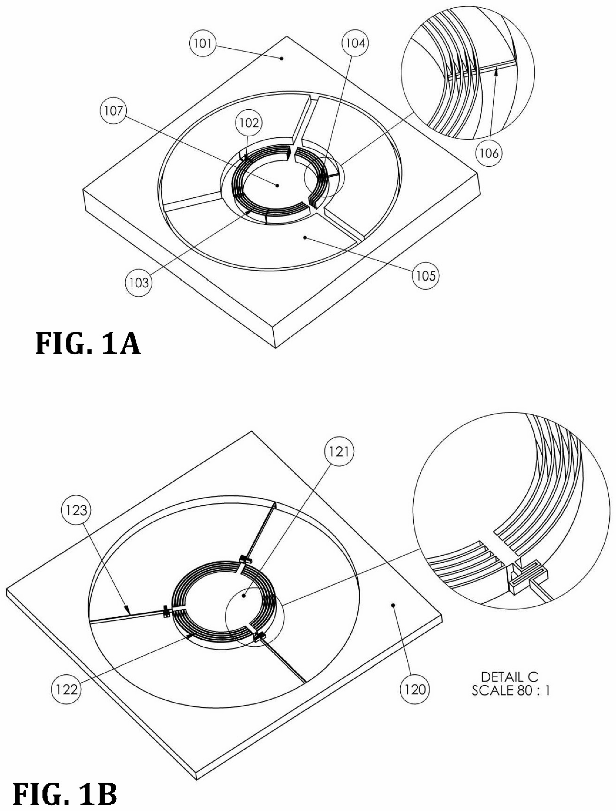

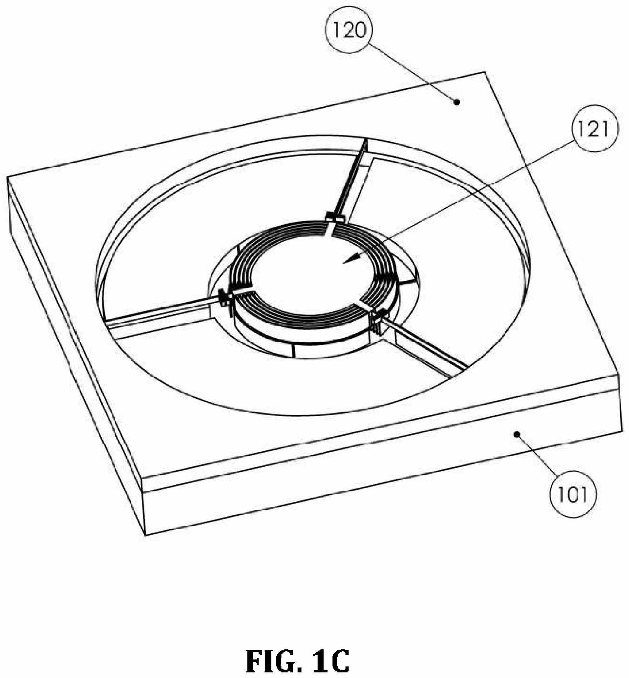

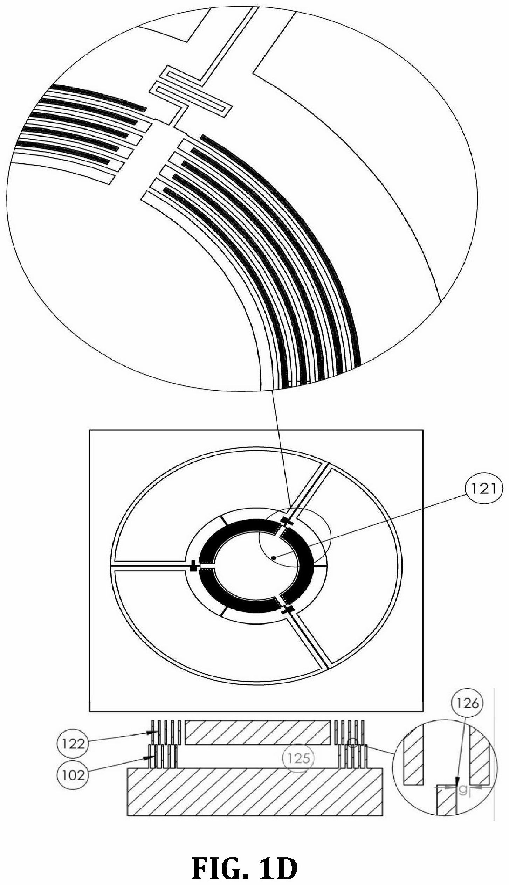

A first embodiment of the present invention (3-DOF MEMS electrostatic actuator) is illustrated in **FIG. 1****.** The fixed structure in this embodiment, illustrated in **FIG. 1A****,** comprises of a plurality of co-centric arc-shaped teeth (pistons) **102, 103, 104,** and the moving structure comprises of a plurality of co-centric arc-shaped slots or openings (tubes) **122 (****FIG.1B****),** which are sized and designed to receive the teeth of the fixed structure.

The teeth or pistons are divided into three stators **102, 103, 104** that are arranged at 120°. Each stator comprises a plurality of arc-shaped pistons, which are vertically aligned with the arc-shaped tubes (openings) **122** in the rotor, so that they inter-digitate during the actuation. The three stators **102, 103, 104** are electrically isolated from one another by utilizing the Buried Oxide (BOX) layer **107** of the SOI wafer. However, the electrodes of each stator are electrically connected via a small thickness (height) layer **106** above the BOX layer. The three circular islands **105** that surround the pistons are electrical pads.

The rotor is fabricated in the device layer of another Si wafer, and it comprises a plurality of arc-shaped tubes **122** that surround the actuator plate **121.** The tubes are attached to the substrate by three supporting beams **123.** The final bonded structure of the actuator is shown in **FIG.1C****.** **FIG.1D** shows the top view of the actuator, and the detailed view, which shows how the pistons (black) and tubes (white) are positioned with respect to each other.

Although this embodiment of the actuator provides 3-DOF motion, it is limited in terms of achieving large rotation angles. This limitation is due to the fact that the horizontal gap (g) **126** between the pistons and the tubes changes as the rotation angle increases, which makes this design improper for providing large rotation angle; however, it is a good design for providing a large translation stroke.

Another limitation of this embodiment is that due to the circular geometry of the pistons, where a volume of air **125** is trapped beneath the actuator plate and the inner side of the innermost pistons, the closest pistons to the center of the actuator plate. This volume of air results in squeeze damping effects between the actuator plate (not the actuator electrodes) and the base during the motion of the rotor. However, these damping effects could be removed by adding a backside etching step of the handle layer of the base SOI wafer.

This embodiment was fabricated using a Direct Reactive Ion Etching (DRIE) bulk micromachining process of SOI wafers. The DRIE of bulk silicon, unlike surface micromachining processes, enables the fabrication of large thickness (height) electrodes that, in turn, enables the actuator to provide a large stroke. The BOX layer of the SOI wafer provides the electrical separation between the stators of the actuator to enable bi-axial rotation.

### Embodiment 2

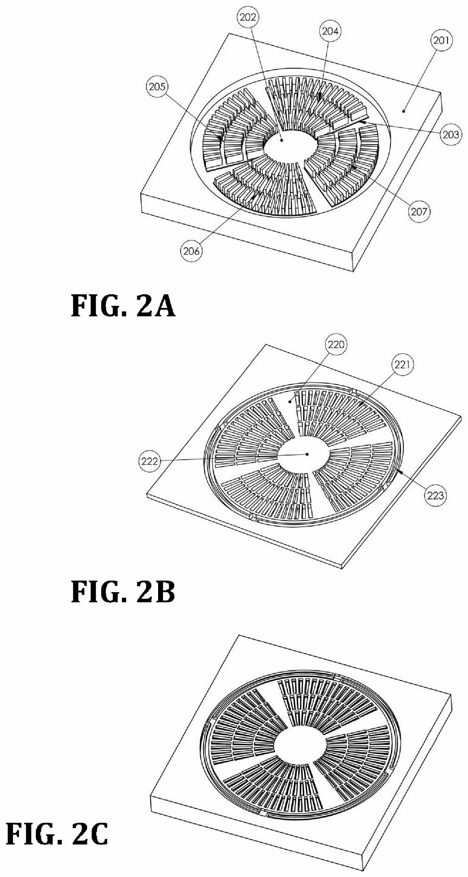

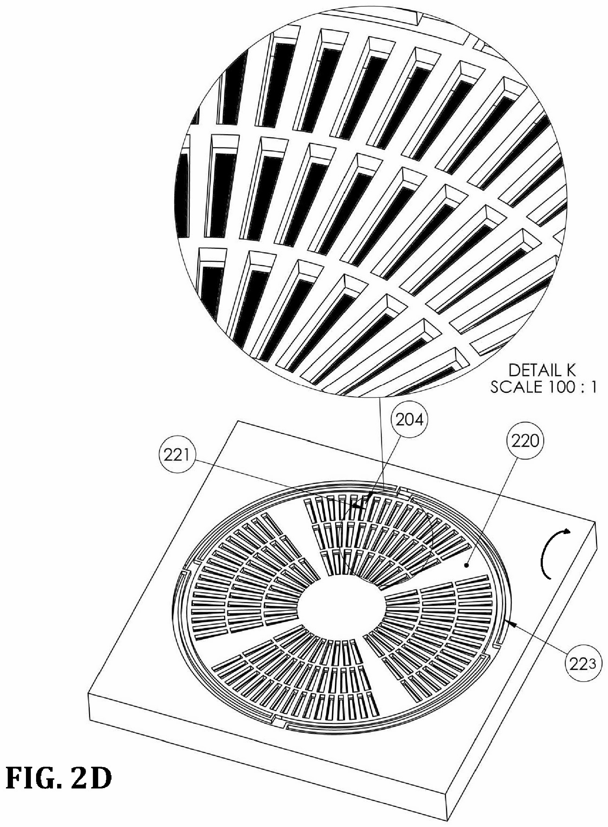

To avoid the limitation in bi-axial rotation of Embodiment 1, the electrodes of the stator and the rotor could be arranged in such a way that reduces changes in the gap **126** during rotation. The pistons **204 205 206 207** in this embodiment, illustrated in **FIG.2A****,** extend radially from the inside to the outside periphery of the actuator. The parallel plate capacitances between the sides of the pistons and tubes extend in the radial direction of the circular plate of the actuator. Therefore, a negligible change in the horizontal gap (g) **126** is expected during rotation of the actuator for those charged piston-tube pairs that are perpendicular or almost perpendicular to the axis of rotation. These charged piston-tube pairs also generate an almost linear torque versus voltage. This is especially when the stator layer is segmented into a large number of stators, see **FIG.2D** (although this figure illustrates 4 stators actuator, the stator layer can be segmented into more stators). That enables this embodiment of the actuator to achieve a large rotation angle before experiencing any pull-in instability as compared to Embodiment **1.** Another advantage of this embodiment is that the parallel plate capacitors formed by the pistons and the tubes are normal to the longitudinal direction of the springs, which is the direction of the highest stiffness of the springs **223** (the longitudinal direction of the springs lies on a tangential direction to the actuator plate). Thus, a large out-of-plane translation stroke could be achieved. Another aspect of this embodiment is the configuration of the springs with respect to the rotor, in which the springs are extending along the peripheral of the rotor (see **FIG.2B** versus **FIG. 1B****).** This configuration of the springs has four advantages. First, it allows springs to be largely long (leads to having a high ratio of the longitudinal stiffness to the transverse stiffness as the longitudinal stiffness of the beams is inversely proportional to the length and the transverse stiffness is inversely proportional to the length cube). This high value of the ratio pushes the lateral instability limit further, so a large stroke could be achieved. The second advantage is that it provides a wide room for electrodes to be multiplied as opposed to the spring configuration of embodiment 1, see **FIG.1****,** in which the springs are extending radially inwards leading to the shrinkage of the area of the rotor. Third, the springs could have the same thickness as the rotor (tubes) layer, meaning the fabrication step needed for etching the rotor layer to soften the spring could be eliminated, which simplifies the fabrication process. Fourth, springs with large height (thickness), similar to the electrodes height, make the MEMS electrostatic actuation more resistant to shock when loaded with a mass such as a lens.

### Embodiment 3

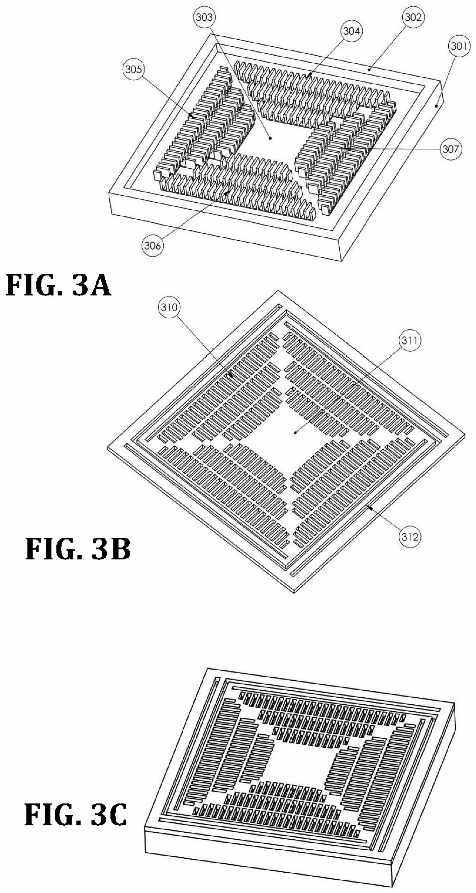

Another embodiment of the actuator is illustrated in **FIG.3****.** The pistons **304 305 306 307** in this embodiment have rectangular cross-sections, and they protrude vertically towards the rotor and extend horizontally along the two in-plane axes (x and y). Each opposing stator contains a plurality of rectangular pistons that also extend horizontally along the two in-plane axes (x and y). The tubes **310** in the rotor are rectangular through holes, and they are facing the pistons so that the pistons penetrate along the tubes during the actuation. This design is more area-efficient in terms of the overall electrodes capacitance than Embodiment 2 in which the corners of the actuator are not utilized due to the geometry of the circular rotor. It also utilizes an efficient spring configuration similar to the one used in embodiment 2. However, the rotation angle of this embodiment is limited due to the change of the horizontal gap between adjacent pistons and tubes, especially, when the actuator plate is rotated towards the corners or the actuator.

### Embodiment 4

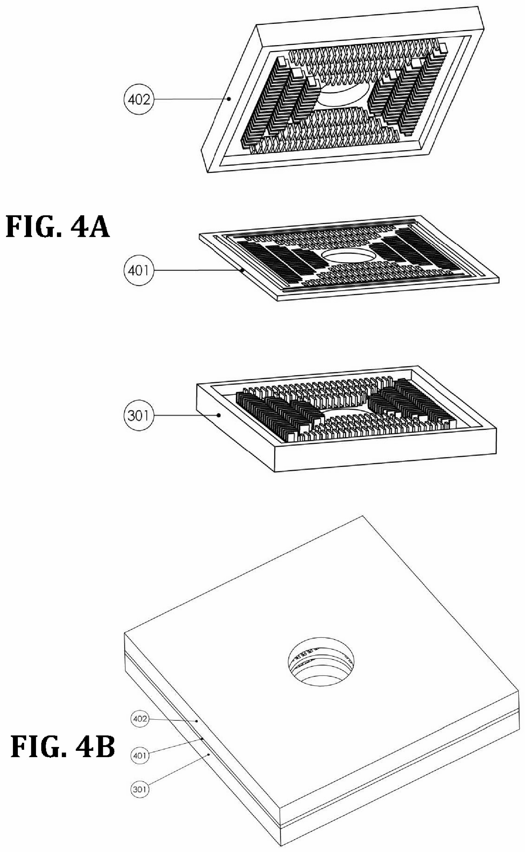

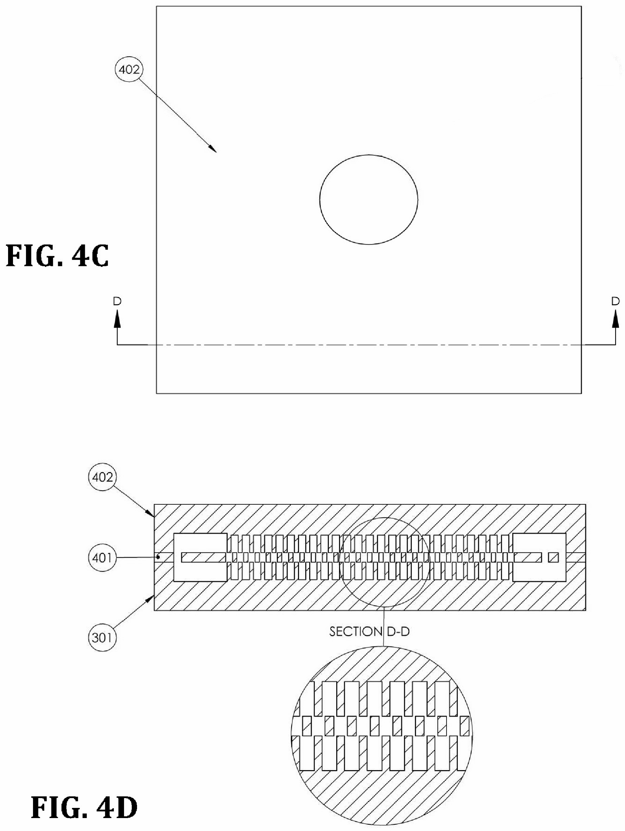

The goal of this embodiment, illustrated in **FIG.4****,** is to double the translation stroke of the actuator described in Embodiment 3. A base **402** with a central open hole and which has the same features as the lower base **301** of the actuator in Embodiment 3 is bonded to the top surface of the rotor **401.** The bonding of this base **402** enables the actuator rotor **401** to translate along the z-axis. Therefore, the stroke of the actuator is doubled as the actuator provides a bi-directional translation. In the rotation mode of the actuator, the torque developed between the rotor and the lower and upper stators increases as more piston-tube pairs are used to generate forces acting on the rotor edges. Therefore, a lower input voltage is required to rotate the rotor. However, bonding misalignments are expected between the upper base **402** pistons and the rotor **401** tubes because the bonding is done after etching the features of both structures (upper base and the rotor). The rotor **401** is attached after bonding to the lower based 301 using backside alignment.

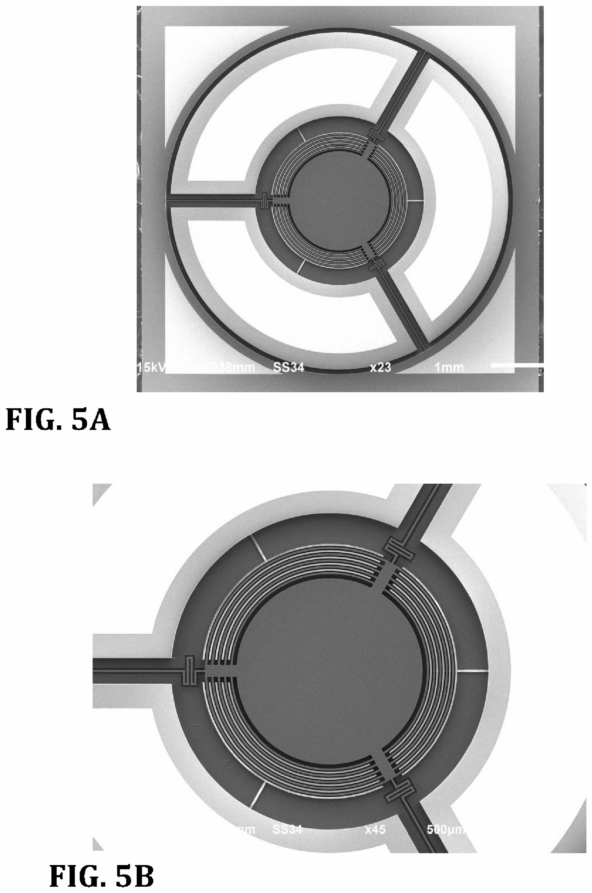

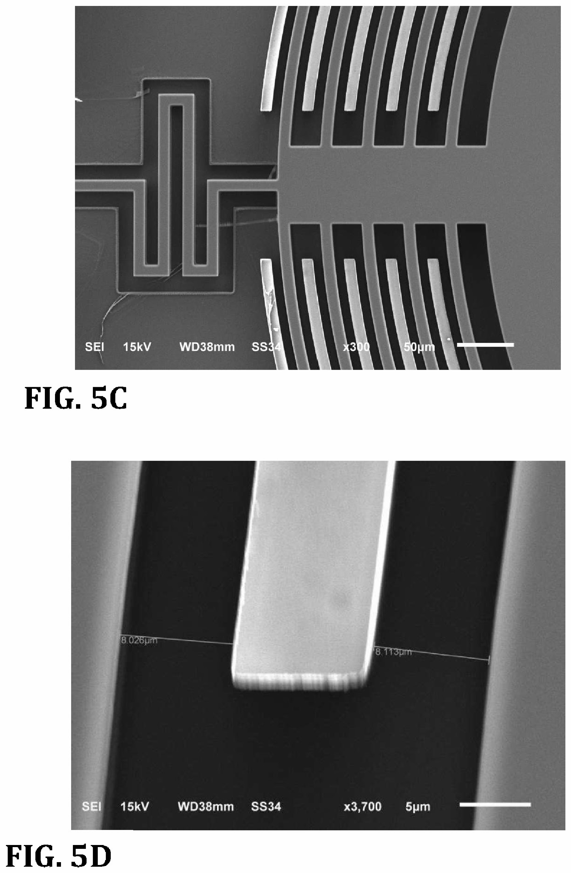

**FIG.5** shows Scanning Electron Microscope (SEM) snapshots from the top side of Embodiment 1 of the actuator, and the alignment accuracy between the electrodes of the actuator was also investigated using the SEM. **FIG.5D** indicates that a high alignment accuracy between the adjacent pistons and tubes was achieved as the misalignment is less than 0.005% of the horizontal gap **126** between the electrodes.

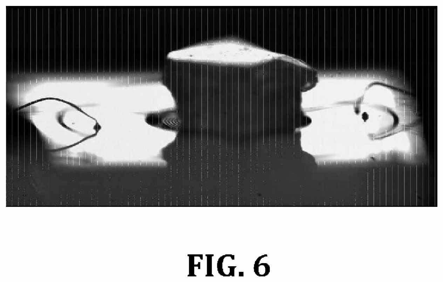

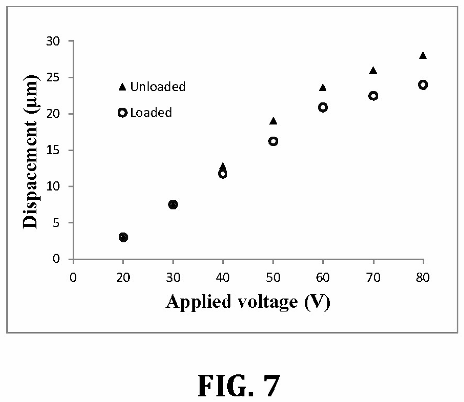

An output force test was conducted on the prototype of Embodiment 1 of the actuator by assessing its static performance when it is loaded with 1 mg mass. The load is placed on the actuator plate using tweezers and then repositioned at the center of the plate using a needle. **FIG.6** is a snapshot of the 1 mg mass loaded actuator during the output force testing. **FIG.7** shows the measured displacements of the loaded actuator versus the applied voltages. The actuator was able to vertically translate the mass load (1 mg) for 24 µm.

The foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.

With respect to the above description, it is to be realized that the optimum relationships for the parts of the invention in regard to size, shape, form, materials, function and manner of operation, assembly and use are deemed readily apparent and obvious to those skilled in the art, and all equivalent relationships to those illustrated in the drawings and described in the specification are intended to be encompassed by the present invention.

### REFERENCES

[1] R. C. Gutierrez, E. R. Fossum, and T. K. Tang, "Auto-Focus Technology," in the 2007 International Image Sensor Workshop, 2007*.*
[2] M. Eromäki, "Optical image stabilization," WO 2013076350 A1.
[3] D. J. Dagel, W. D. Cowan, S. Member, O. B. Spahn, G. D. Grossetete, A. J. Griñe, M. J. Shaw, P. J. Resnick, and B. Jokiel, "Large-Stroke MEMS Deformable Mirrors for Adaptive Optics," vol. 15, no. 3, pp. 572-583, 2006.
[4] Digital Optics Corporation, "Advances in Autofocus Camera Technologies made possible by MEMS," 2012.
[5] B. S. Kim, J. S. Park, C. Moon, G. M. Jeong, and H. S. Ahn, "A precision robot system with modular actuators and MEMS micro gripper for micro system assembly," J. Mech. Sci. Technol., vol. 22, no. 1, pp. 70-76, Apr. 2008.
[6] A. P. Lee, D. R. Ciarlo, P. A. Krulevitch, S. Lehew, J. Trevino, and M. a. Northrup, "A Practical Microgripper By Fine Alignment, Eutectic Bonding And Sma Actuation," Proc. Int. Solid-State Sensors Actuators Conf. - TRANSDUCERS '95, vol. 2, pp. 368-371, 1995.
[7] D. J. Bell, T. J. Lu, N. A. Fleck, and S. M. Spearing, "MEMS actuators and sensors: observations on their performance and selection for purpose," J. Micromechanics Microengineering, vol. 15, no. 7, pp. S153-S164, Jul. 2005.
[8] D. A. Henderson, "Micro-Scale Smart Actuator Modules for Imaging Systems," in ACTUATOR 2012, 2012, no. June.
[9] C. Liu, "Electrostatic Actuation," in Foundations of MEMS, Second., 2005, pp. 127-168.
[10] J. Li, "Electrostatic Zipping Actuators and Their Application to MEMS," Thesis, 2004*.*
[11] V. Milanovic, G. a. Matus, and D. T. McCormick, "Gimbal-Less Monolithic Silicon Actuators for Tip-Tilt-Piston Micromirror Applications," IEEE J. Sel. Top. Quantum Electron., vol. 10, no. 3, pp. 462-471, May 2004.
[12] Y. Li, D. Psychogiou, S. Kühne, J. Hesselbarth, C. Hafner, and C. Hierold, "Large Stroke Staggered Vertical Comb-Drive Actuator for the Application of a Millimeter-Wave Tunable Phase Shifter," J. MICROELECTROMECHANICAL Syst., vol. 22, no. 4, pp. 962-975, 2013.
[13] G. W. Roman C. Gutierrez, "Lens Barrel with MEMS Actautor," US 2012121242A12012.
[14] S. He and R. Ben Mrad, "Translating and Rotation Micro Mechanism," US 8269395 B22011.
[15] E. Carr, S. Olivier, and O. Solgaard, "Large-Stroke Self-Aligned Vertical Comb Drive Actuators for Adaptive Optics Applications," SPIE, vol. 6113, p. 61130T-61130T9, Jan. 2006.
[16] R. L. clarck, J. A. Hammer, and J. R. Karpinsky, "Vertical Comb drive Actuated Deformable Mirror Device and Method," US6384952 B12002.
[17] K. Akira, M. Yoshihiro, and K. Osamu, "Microactuator Having Increased Rigidity with Reduced Mass," US7538471 B22009.

## Claims

1. A MEMS electrostatic microactuator, comprising:
a. a first base plate (101; 201; 301; 402) having a top surface and a thickness;
b. a cavity constructed at the center of the top surface of the base plate;
c. an array of spaced apart teeth electrodes (102, 103, 104; 204, 205, 206, 207) constructed in the thickness of said base plate, wherein said array of teeth electrodes surrounding said cavity, wherein said cavity being a closed or an open cavity;
d. each said tooth electrode having a shape, a length, a height, and a thickness;
e. said array of teeth being grouped in one or multiple sub-arrays of teeth each comprising one or more teeth, wherein the teeth in each sub-array of teeth being electrically connected to each other and electrically isolated from other sub-array of teeth;
f. each sub-array of teeth being electrically addressable, whereby each sub-array of teeth forms a stator of said actuator;
g. a second plate (120) attached to said base plate and having a structure sized to fit on said base plate, said second plate having a fixed peripheral structure and a moving central structure, whereby the fixed peripheral structure being attached to the base plate and the moving central structure;
h. an actuator plate (121) held by the moving central structure of the second plate, the cavity of the first base plate being sized to receive the actuator plate;
i. an array of spaced apart openings constructed in the thickness of said second plate;
j. said array of openings (122; 221; 310) sized and designed to receive and interdigitate with said array of teeth, each said opening having a length, width and a height, and **characterized in that**;
k. said array of openings being grouped into one or multiple sub-arrays of openings that each comprises one or more openings, wherein each sub-array of openings being electrically connected to each other and electrically isolated from other sub-array of openings, whereby each sub-array of openings forms a rotor of said actuator; and either:
a plurality of spring means (223) extended along the peripheral structure of said second plate to attach each said rotor to said peripheral structure, and to return the rotor to its initial position in the absence of a driving voltage, each said spring having a length, a thickness, and a height: or
each rotor is supported by one or more supporting beams (123) extended from the fixed peripheral structure of the second plate to hold them aligned with respect to said array of teeth; and
whereby the teeth of the stators penetrate into the openings of the rotors during the actuation in response to electrostatic forces from a drive voltage applied between said stators and rotors, and a 3-DOF actuation being achieved by selectively charging each sub-array of teeth and openings.

2. The MEMS electrostatic microactuator of claim 1, wherein said array of teeth electrodes being arc shaped and being radially co-centric with a predefined radial spacing.

3. The MEMS electrostatic microactuator of claim 2, wherein said microactuator comprising of three equal size sub-arrays, whereby both translational and rotational actuations can be obtained by activating each sub-array.

4. The MEMS electrostatic microactuator of claim 1, wherein said array of teeth electrodes being substantially rectangular, circular, triangular, trapezoidal, pentagonal, or hexagonal shaped, and each said sub-array of teeth being aligned linearly along their length and forming several linear rows in each said sub-array.

5. The MEMS electrostatic microactuator of claim 1, wherein said array of teeth electrodes being substantially rectangular, circular, triangular, trapezoidal, pentagonal, or hexagonal shaped, and each said sub-array of teeth being aligned radially along their length and forming several curved rows in each said sub-array.

6. The MEMS electrostatic microactuator of claim 4 and 5, wherein said microactuator comprising of four equal size sub-arrays.

7. The MEMS electrostatic microactuator of claim 1, wherein said MEMS actuator being fabricated in a Si/SOI wafer using a Direct Reactive Ion Etching bulk micromachining process.

8. The MEMS electrostatic microactuator of claim 1, wherein said springs being long springs having high ratio of the longitudinal stiffness to the transverse stiffness to allow for a large stroke actuation.

9. The MEMS electrostatic microactuator of claim 1, wherein said springs being extended radially inwards.

10. The MEMS electrostatic microactuator of claim 1, wherein said springs having a height being substantially the same as the height of the openings, whereby making the MEMS electrostatic actuation more resistant to shock when loaded with a mass.

11. The MEMS electrostatic microactuator of claim 1, wherein said actuator plate having an opening, and an optical element being attached to said opening on said actuator plate, whereby said cavity in the base and said optical element allow for the penetration of light through the actuator.

12. The MEMS electrostatic microactuator of claim 1, further having:
a. a third base plate, wherein said second plate being sandwiched between the first and the third base plates; and
b. said third base plate being mirror image of said first base plate, having a thickness, a central cavity, an array of spaced apart teeth electrodes constructed in the thickness of said third base plate, wherein said array of teeth electrodes surrounding said cavity, each said tooth electrode having a shape, a length, a height, and a thickness, said array of teeth being grouped in one or multiple sub-arrays of teeth that each comprise one or more teeth, wherein the teeth in each sub-array of teeth being electrically connected to each other and electrically isolated from other sub-array of teeth, each sub-array of teeth being electrically addressable, whereby each sub-array of teeth forms a stator of said microactuator;
whereby through a reciprocating motion of the rotors, the teeth of the stators on each base plate penetrate into the openings of the rotors during the actuation in response to electrostatic forces from a drive voltage applied between said stators and rotors, and a 3- DOF actuation being achieved by selectively charging each sub-array of teeth and openings.

## Patentansprüche

1. Elektrostatischer MEMS-Mikroaktuator, umfassend:
a. eine erste Basisplatte (101; 201; 301; 402), aufweisend eine obere Fläche und eine Dicke;
b. eine Aussparung, die an der Mitte der oberen Fläche der Basisplatte konstruiert ist;
c. ein Array von voneinander beabstandeten Zahnelektroden (102, 103, 104; 204, 205, 206, 207), das in der Dicke der besagten Basisplatte konstruiert ist, wobei das besagte Array von Zahnelektroden die besagte Aussparung umgibt, wobei die besagte Aussparung eine geschlossene oder eine offene Aussparung ist;
d. wobei jede besagte Zahnelektrode eine Form, eine Länge, eine Höhe und eine Dicke aufweist;
e. wobei das besagte Array von Zähnen zu einem oder mehreren Unterarrays von Zähnen gruppiert ist, die jeweils einen oder mehrere Zähne umfassen, wobei die Zähne in jedem Unterarray von Zähnen miteinander elektrisch verbunden sind und von anderen Unterarrays von Zähnen elektrisch isoliert sind;
f. wobei jedes Unterarray von Zähnen elektrisch adressierbar ist, wobei jedes Unterarray von Zähnen einen Stator des besagten Aktuators bildet;
g. eine zweite Platte (120), die an der besagten Basisplatte angebracht ist und eine Struktur aufweist, die dazu dimensioniert ist, auf die besagte Basisplatte zu passen, wobei die besagte zweite Platte eine feststehende Umfangsstruktur und eine bewegliche zentrale Struktur aufweist, wodurch die feststehende Umfangsstruktur an der Basisplatte und der beweglichen zentralen Struktur angebracht ist;
h. eine Aktuatorplatte (121), die von der beweglichen zentralen Struktur der zweiten Platte gehalten wird, wobei die Aussparung der ersten Basisplatte dazu dimensioniert ist, die Aktuatorplatte aufzunehmen;
i. ein Array von voneinander beabstandeten Öffnungen, das in der Dicke der besagten zweiten Platte konstruiert ist;
j. wobei das Array von Öffnungen (122; 221; 310) dazu dimensioniert und entworfen ist, das besagte Array von Zähnen aufzunehmen und mit diesem ineinanderzugreifen, wobei jede besagte Öffnung eine Länge, eine Breite und eine Höhe aufweist, und **dadurch gekennzeichnet, dass**
k. das besagte Array von Öffnungen zu einem oder mehreren Unterarrays von Öffnungen gruppiert ist, die jeweils eine oder mehrere Öffnungen umfassen, wobei jedes Unterarray von Öffnungen miteinander elektrisch verbunden ist und von anderen Unterarrays von Öffnungen elektrisch isoliert ist, wobei jedes Unterarray von Öffnungen einen Rotor des besagten Aktuators bildet; und entweder:
eine Vielzahl von Federmitteln (223), die entlang der Umfangsstruktur der besagten zweiten Platte erstreckt ist, um jeden besagten Rotor an der besagten Umfangsstruktur anzubringen und um den Rotor in Abwesenheit einer Antriebsspannung in seine Anfangsposition zurückzubringen, wobei jede besagte Feder eine Länge, eine Dicke und eine Höhe aufweist; und
jeder Rotor von einem oder mehreren Tragebalken (123) getragen wird, die von der feststehenden Umfangsstruktur der zweiten Platte erstreckt sind, um sie in Bezug auf das besagte Array von Zähnen ausgerichtet zu halten; und
wobei die Zähne der Statoren während der Betätigung als Reaktion auf elektrostatische Kräfte von einer Antriebsspannung, die zwischen den besagten Statoren und den besagten Rotoren angelegt wird, und einer 3-DOF-Betätigung, die durch selektives Laden jedes Unterarrays von Zähnen und Öffnungen erzielt wird, in die Öffnungen der Rotoren eindringen.

2. Elektrostatischer MEMS-Mikroaktuator nach Anspruch 1, wobei das besagte Array von Zahnelektroden bogenförmig ist und radial kozentrisch mit einem vordefinierten radialen Abstand ist.

3. Elektrostatischer MEMS-Mikroaktuator nach Anspruch 2, wobei der besagte Mikroaktuator drei Unterarrays von gleicher Größe umfasst, wobei sowohl Translations- und Drehbetätigungen durch Aktivieren jedes Unterarrays erhalten werden können.

4. Elektrostatischer MEMS-Mikroaktuator nach Anspruch 1, wobei das besagte Array von Zahnelektroden im Wesentlichen rechteckig, kreisförmig, dreieckig, trapezförmig, fünfeckig oder sechseckig geformt ist und jedes besagte Unterarray von Zähnen linear entlang ihrer Länge ausgerichtet ist und mehrere lineare Reihen in jedem besagten Unterarray bildet.

5. Elektrostatischer MEMS-Mikroaktuator nach Anspruch 1, wobei das besagte Array von Zahnelektroden im Wesentlichen rechteckig, kreisförmig, dreieckig, trapezförmig, fünfeckig oder sechseckig geformt ist und jedes besagte Unterarray von Zähnen radial entlang ihrer Länge ausgerichtet ist und mehrere gewölbte Reihen in jedem besagten Unterarray bildet.

6. Elektrostatischer MEMS-Mikroaktuator nach Anspruch 4 oder 5, wobei der besagte Mikroaktuator vier Unterarrays von gleicher Größe umfasst.

7. Elektrostatischer MEMS-Mikroaktuator nach Anspruch 1 wobei der besagte MEMS-Aktuator in einem Si/SOI-Wafer unter Verwendung eines Massenmikrobearbeitungsvorgangs mit direktem reaktivem Ionenätzen gefertigt wird.

8. Elektrostatischer MEMS-Mikroaktuator nach Anspruch 1, wobei die besagten Federn lange Federn mit einem hohen Verhältnis der Längssteifigkeit zu der Quersteifigkeit sind, um eine große Hubbetätigung zu ermöglichen.

9. Elektrostatischer MEMS-Mikroaktuator nach Anspruch 1, wobei die besagten Federn radial nach innen erstreckt werden.

10. Elektrostatischer MEMS-Mikroaktuator nach Anspruch 1, wobei die besagten Federn eine Höhe aufweisen, die im Wesentlichen identisch mit der Höhe der Öffnungen ist, wobei die elektrostatische MEMS-Betätigung bei Belastung mit einer Masse gegenüber Stößen widerstandsfähiger gemacht wird.

11. Elektrostatischer MEMS-Mikroaktuator nach Anspruch 1, wobei die besagte Aktuatorplatte eine Öffnung aufweist und ein optisches Element an der besagten Öffnung auf der besagten Aktuatorplatte angebracht ist, wobei die besagte Aussparung in der Basis und das besagte optische Element das Eindringen von Licht durch den Aktuator ermöglichen.

12. Elektrostatischer MEMS-Mikroaktuator nach Anspruch 1, ferner aufweisend:
a. eine dritte Basisplatte, wobei die besagte zweite Platte zwischen der ersten und der dritten Basisplatte eingeschoben ist; und
b. wobei die dritte Basisplatte ein Spiegelbild von der besagten ersten Basisplatte ist, eine Dicke, eine zentrale Aussparung, ein Array von voneinander beabstandeten Zahnelektroden aufweist, das in der Dicke der besagten dritten Basisplatte konstruiert ist, wobei das besagte Array von Zahnelektroden die besagte Aussparung umgibt, wobei jede besagte Zahnelektrode eine Form, eine Länge, eine Höhe und eine Dicke aufweist, wobei das besagte Array von Zähnen zu einem oder mehreren Unterarrays von Zähnen gruppiert ist, die jeweils einen oder mehrere Zähne umfassen, wobei die Zähne in jedem Unterarray von Zähnen miteinander elektrisch verbunden sind und von anderen Unterarrays von Zähnen elektrisch isoliert sind, wobei jedes Unterarray von Zähnen elektrisch adressierbar ist, wobei jedes Unterarray von Zähnen einen Stator des besagten Mikroaktuators bildet;
wobei die Zähne der Statoren auf jeder Basis durch eine Hin- und Herbewegung der Rotoren während der Betätigung als Reaktion auf elektrostatische Kräfte von einer Antriebsspannung, die zwischen den besagten Statoren und den besagten Rotoren angelegt wird, und einer 3-DOF-Betätigung, die durch selektives Laden jedes Unterarrays von Zähnen und Öffnungen erzielt wird, in die Öffnungen der Rotoren eindringen.

## Revendications

1. Un microactionneur électrostatique MEMS, comprenant :
a. une première plaque de base (101 ; 201 ; 301 ; 402) présentant une surface supérieure et une épaisseur ;
b. une cavité ménagée au centre de la surface supérieure de la plaque de base ;
c. un réseau d'électrodes en forme de dents espacées les unes des autres (102, 103, 104 ; 204, 205, 206, 207) formé dans l'épaisseur de ladite plaque de base, dans lequel, ledit réseau d'électrodes en forme de dents entoure ladite cavité, ladite cavité étant une cavité fermée ou une cavité ouverte ;
d. chaque dite électrode en forme de dent présentant une forme, une longueur, une hauteur et une épaisseur ;
e. ledit réseau de dents étant subdivisé en un ou plusieurs sous-réseaux de dents comprenant chacun une ou plusieurs dents, les dents de chaque sous-réseau étant connectées électriquement entre elles et isolées électriquement des autres sous-réseaux de dents ;
f. chaque sous-réseau de dents étant adressable électriquement, de manière à ce que chaque sous-réseau de dents forme un stator dudit actionneur ;
g. une seconde plaque (120) solidarisée à ladite plaque de base et dont la structure est dimensionnée pour s'adapter à ladite plaque de base, ladite seconde plaque comportant une structure périphérique fixe et une structure centrale mobile, la structure périphérique fixe étant solidarisée à la plaque de base et à la structure centrale mobile ;
h. une plaque d'actionneur (121) portée par la structure centrale mobile de la seconde plaque, la cavité de la première plaque de base étant dimensionnée de façon à loger la plaque d'actionneur ;
i. un réseau d'ouvertures espacées ménagé dans l'épaisseur de ladite seconde plaque ;
j. ledit réseau d'ouvertures (122 ; 221 ; 310) étant dimensionné et conçu pour recevoir ledit réseau de dents et s'interdigiter avec ledit réseau de dents, chaque dite ouverture présentant une longueur, une largeur et une hauteur, et **caractérisé en ce que** ;
k. ledit réseau d'ouvertures étant subdivisé en un ou plusieurs sous-réseaux d'ouvertures comprenant chacun une ou plusieurs ouvertures, les ouvertures de chaque sous-réseau d'ouvertures étant connectées électriquement entre elles et isolées électriquement des autres sous-réseaux d'ouvertures, de manière à ce que chaque sous-réseau d'ouvertures forme un rotor dudit actionneur ; et soit :
une pluralité de moyens élastiques (223) s'étendant le long de la structure périphérique de ladite seconde plaque pour solidariser chaque dit rotor à ladite structure périphérique, et pour rappeler le rotor dans sa position initiale en l'absence de tension d'excitation, chaque dit ressort présentant une longueur, une épaisseur et une hauteur ; ou soit
chaque rotor est porté par une ou plusieurs poutres de support (123) prolongées depuis la structure périphérique fixe de la seconde plaque de façon à assurer leur alignement par rapport audit réseau de dents ; et
de sorte que les dents des stators pénètrent dans les ouvertures des rotors lors de l'actionnement sous l'effet de forces électrostatiques issues d'une tension d'excitation appliquée entre lesdits stators et rotors, un actionnement à 3 degrés de liberté étant ainsi assuré par la charge sélective de chaque sous-réseau de dents et de chaque sous-réseau d'ouvertures.

2. Le microactionneur électrostatique MEMS selon la revendication 1, dans lequel ledit réseau d'électrodes en forme de dents présente une configuration en arc de cercle et une disposition radiale concentrique selon un espacement radial prédéfini.

3. Le microactionneur électrostatique MEMS selon la revendication 2, dans lequel ledit microactionneur comprend trois sous-réseaux de dents de dimensions égales, de sorte que des actionnements tant en translation qu'en rotation peuvent être obtenus par l'activation de chaque sous-réseau de dents.

4. Le microactionneur électrostatique MEMS selon la revendication 1, dans lequel ledit réseau d'électrodes en forme de dents présente une forme sensiblement rectangulaire, circulaire, triangulaire, trapézoïdale, pentagonale ou hexagonale, et chaque dit sous-réseau de dents est aligné de manière linéaire sur sa longueur de façon à former plusieurs rangées linéaires dans chaque dit sous-réseau de dents.

5. Le microactionneur électrostatique MEMS selon la revendication 1, dans lequel ledit réseau d'électrodes en forme de dents présente une forme sensiblement rectangulaire, circulaire, triangulaire, trapézoïdale, pentagonale ou hexagonale, et chaque dit sous-réseau de dents est aligné de manière radiale sur sa longueur de façon à former plusieurs rangées courbes dans chaque dit sous-réseau de dents.

6. Le microactionneur électrostatique MEMS selon les revendications 4 et 5, dans lequel ledit microactionneur comprend quatre sous-réseaux de dents de dimensions égales.

7. Le microactionneur électrostatique MEMS selon la revendication 1, dans lequel ledit actionneur MEMS est réalisé sur tranche de Si/SOI (silicium sur silicium-sur-isolant) par un procédé de micro-usinage de volume par gravure ionique réactive profonde.

8. Le microactionneur électrostatique MEMS selon la revendication 1, dans lequel lesdits moyens élastiques sont des ressorts longs présentant un rapport élevé entre la raideur longitudinale et la raideur transversale de façon à permettre un actionnement à grande course.

9. Le microactionneur électrostatique MEMS selon la revendication 1, dans lequel lesdits moyens élastiques s'étendent de manière radiale vers l'intérieur.

10. Le microactionneur électrostatique MEMS selon la revendication 1, dans lequel lesdits moyens élastiques présentent une hauteur sensiblement identique à la hauteur des ouvertures, de façon à conférer à l'actionnement électrostatique MEMS une résistance accrue aux chocs en présence d'une masse en charge.

11. Le microactionneur électrostatique MEMS selon la revendication 1, dans lequel ladite plaque d'actionneur présente une ouverture, et un élément optique est solidarisé à ladite ouverture sur ladite plaque d'actionneur, de sorte que ladite cavité ménagée dans la base et ledit élément optique permettent le passage de la lumière à travers l'actionneur.

12. Le microactionneur électrostatique MEMS selon la revendication 1, comportant en outre :
a. une troisième plaque de base, et une première plaque de base entre lesquelles est intercalée ladite seconde plaque ; et
b. ladite troisième plaque de base formant une symétrie miroir par rapport à ladite première plaque de base, présentant une épaisseur ainsi qu'une cavité centrale, et intégrant dans son épaisseur un réseau d'électrodes en forme de dents espacées, dans lequel, ledit réseau d'électrodes en forme de dents entourant ladite cavité, et chaque dite électrode en forme de dent présentant une forme, une longueur, une hauteur et une épaisseur définies, ledit réseau de dents étant subdivisé en un ou plusieurs sous-réseaux de dents comprenant chacun une ou plusieurs dents, les dents de chaque sous-réseau de dents
étant connectées électriquement entre elles et isolées électriquement les unes des autres sous-réseaux de dents, dans lequel, chaque sous-réseau de dents étant adressable électriquement de façon à constituer un stator dudit microactionneur ;
de sorte que, par un mouvement alternatif des rotors, les dents des stators de chaque plaque de base pénètrent dans les ouvertures des rotors lors de l'actionnement sous l'effet de forces électrostatiques induites par une tension d'excitation appliquée entre lesdits stators et rotors, la charge sélective de chaque sous-réseau de dents et de chaque sous-réseau d'ouvertures permettant ainsi un actionnement à 3 degrés de liberté.
